(19) Europäisches Patentamt / European Patent Office / Office européen des brevets

(11) **EP 4 212 336 A1**

(12) **EUROPEAN PATENT APPLICATION**
published in accordance with Art. 153(4) EPC

(43) Date of publication:
**19.07.2023 Bulletin 2023/29**

(21) Application number: **20953430.4**

(22) Date of filing: **24.11.2020**

(51) International Patent Classification (IPC):
**B32B 27/36** (2006.01)  **B32B 27/08** (2006.01)
**B32B 27/28** (2006.01)  **B32B 27/18** (2006.01)
**C08J 9/42** (2006.01)  **B32B 15/08** (2006.01)
**B32B 15/20** (2006.01)  **B32B 7/12** (2006.01)
**B32B 7/025** (2019.01)

(86) International application number:
**PCT/KR2020/016692**

(87) International publication number:
**WO 2022/055028 (17.03.2022 Gazette 2022/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.09.2020 KR 20200115972**

(71) Applicant: **Sang-a Frontec Co., Ltd**
**Incheon 21629 (KR)**

(72) Inventors:
• JEONG, Ji Hong
  Incheon 22002 (KR)
• CHO, Woo Hyun
  Incheon 21629 (KR)
• KIM, Won Soo
  Incheon 21667 (KR)
• KIM, Du Yeong
  Incheon 22176 (KR)

(74) Representative: **Fenix Legal KB**
**Östermalmstorg 1, 3tr.**
**114 42 Stockholm (SE)**

(54) **LOW DIELECTRIC COMPOSITE FILM FOR COPPER CLAD LAMINATE (CCL), AND LOW DIELECTRIC COPPER CLAD LAMINTE (CCL) COMPRISING SAME**

(57) The present invention relates to a low dielectric composite film for a copper clad laminate (CCL), and more specifically to a low dielectric composite film for a copper clad laminate (CCL) and a low dielectric copper clad laminate including the same, which exhibit a remarkably low dielectric constant and dielectric loss, excellent mechanical properties and a remarkably low coefficient of thermal expansion.

【FIG. 1】

EP 4 212 336 A1

**Description**

CROSS-REFERENCE TO RELATED APPLICATION

This application claims priority to and the benefit of Korean Patent Application No. 10-2020-0115972, filed on September 10, 2020, the disclosure of which is incorporated herein by reference in its entirety.

[Technical Field]

The present invention relates to a low dielectric composite film for a copper clad laminate (CCL), and more specifically to a low dielectric composite film for a copper clad laminate (CCL) and a low dielectric copper clad laminate including the same, which exhibit a remarkably low dielectric constant and dielectric loss, excellent mechanical properties and a remarkably low coefficient of thermal expansion.

[Background Art]

The era of downloading 1 GB in 10 seconds, that is, the era of 5th generation mobile communication networks (5G Networks) has begun. In the International Consumer Electronics Show 2017 (CES 2017), just as Intel announced the world's first 5G modem and predicted that innovation will occur in various fields such as autonomous vehicles, Internet of Things, wireless broadband and the like based on gigabit speed, mobile carrier companies are already moving to 5G mobile communications. The International Telecommunication Union (ITU) held a radio communication assembly in October 2015 and set the official technology name for 5G as 'IMT (International Mobile Telecommunication)-2020.' 5G stands for '5th generation mobile communications.'

According to the definitions of the International Telecommunication Union (ITU), 5G is a mobile communication technology in which the maximum download speed is 20 Gbps and the minimum download speed is 100 Mbps. In addition, it should be able to provide Internet of Things (IoT) services to 1 million devices within a radius of 1 km², and free communication should be possible even on highspeed trains at a speed of 500 km/hour. The 5G download speed is faster by 70 times or more than the current mobile communication speed of 300 Mbps and 280 times faster than the current mobile communication speed of normal LTE. This is the speed at which a 1GB movie can be downloaded in 10 seconds. 5G is not concerned only with transmission speed. The response speed has been noticeably improved as well as the transmission speed. If the data transmission speed is an indicator which indicates how much data can pass at a time, the response speed measures the time it takes for small data to pass through. In 4G, the response speed has been increased to 10 to 50 ms (milliseconds, thousandths of a second). In 5G, the response speed has been increased by about 10 times. Thanks to this, 5G will be actively introduced in the fields of autonomous vehicles and the Internet of Things (IoT) field, where large amounts of data must be exchanged seamlessly with a central server.

Meanwhile, unlike 4G using a frequency of 2 GHz or less, 5G uses an ultrahigh band frequency of 28 GHz. The signals transmitted and received in a mobile communication system are radio waves, and in recent years, 5G, which is currently under construction, uses high-frequency bands of 3.5 GHz and 28 GHz, and uses significantly higher high-frequency bands compared to 4G. Therefore, the situation is that more base stations or repeaters than 4G are required due to the communication characteristics of lower diffraction (strong straightness) and shorter radio wave reach than 4G.

An electrical signal has a characteristic in which the transmission loss is increased as much as the frequency is increased. Since a low dielectric constant and a dielectric loss cannot be achieved at a desired level in the conventional low dielectric film and copper clad laminate, signal interference in the high frequency band could not be minimized or prevented, and even if a predetermined low dielectric constant was expressed, there have been problems in that mechanical properties were deteriorated or the coefficient of thermal expansion was high.

Accordingly, the situation is that there is an urgent need to develop a material in which a dielectric constant and a dielectric loss are remarkably low, mechanical properties are excellent, and a coefficient of thermal expansion is remarkably low.

[Disclosure]

[Technical Problem]

The present invention has been devised in consideration of the aforementioned points, and is directed to providing a low dielectric composite film for a copper clad laminate (CCL) and a low dielectric copper clad laminate including the same, which exhibit a remarkably low dielectric constant and dielectric loss, excellent mechanical properties and a remarkably low coefficient of thermal expansion.

[Technical Solution]

In order to solve the above-described problems, the present invention provides a low dielectric composite film for a copper clad laminate (CCL), including a core layer having a porous substrate including expanded polytetrafluoroethylene (ePTFE) and having a plurality of pores, and a polyimide-based matrix which is formed by including a polyimide-based compound and filled in the pores of the porous substrate.

According to an exemplary embodiment of the present invention, the porous substrate may be 20 to 85% by weight based on the total weight of the core layer.

In addition, the porous substrate may be 15 to 80% by volume based on the total volume of the core layer.

In addition, the core layer may be provided on at least one of the upper and lower surfaces of the porous substrate and further include a polyimide-based layer derived from the polyimide-based matrix.

In addition, the polyimide-based layer may be 8 to 80% by volume based on the total volume of the core layer.

In addition, the porous substrate may have a ratio of tensile strength in MD direction to tensile strength in TD direction of 1: 0.4 to 2.5.

In addition, the thickness ratio of the total thickness of the polyimide-based layer to the thickness of the porous substrate may be 1:0.2 to 12.

In addition, the core layer may include a first polyimide-based layer and a second polyimide-based layer on the upper and lower surfaces of the porous substrate, respectively, and wherein the first polyimide-based layer and the second polyimide-based layer may have a thickness ratio of 1: 0.5 to 1.5.

In addition, the polyimide-based matrix may have an imidization ratio of 90% or more as measured according to Measurement Method 1 below:

[Measurement Method 1]

Assuming that the imidization ratio of a reference sample imidized at 380°C for 60 minutes is 100%, the peak sizes at wavelengths of 1,700 $cm^{-1}$ and 1,615 $cm^{-1}$ are measured with respect to the polyimide-based matrix through an infrared spectrometer, and after calculating the PI index according to Mathematical Formula 1 below, the imidization ratio is calculated according to Mathematical Formula 2 below.

[Mathematical Formula 1]

$$\text{PI index} = \text{Peak area at wavelength of } 1{,}700 \text{ cm}^{-1} \text{ (PI Peak)} / \text{Peak area at wavelength of } 1{,}615 \text{ cm}^{-1} \text{ (PAA Peak)}$$

[Mathematical Formula 2]

$$\text{Imidization ratio } (\%) = (\text{PI index of polyimide-based matrix} / \text{PI index of reference sample}) \times 100 \ (\%)$$

In addition, the low dielectric composite film may further include an adhesive layer on one or both sides of the core layer.

In addition, the polyimide-based matrix may be formed by imidization of polyamic acid formed through polymerization of dianhydride including at least one selected from the group consisting of BPDA (3,3',4,4'-Biphenyltetracarboxylic dianhydride), PMDA (pyromellitic dianhydride), ODPA (4,4'-oxydiphthalic anhydride), BTDA (3,3',4,4'-benzophenone tetracarboxylic dianhydride), BPADA (2,2-bis[4-(3,4-dicarboxyphenoxy)phenyl]propane dianhydride), TAHQ (ditricarboxylic anhydride hydroquinone ester), 6FDA (2,2-bis(3,4-anhydrodicarboxyphenyl)hexafluoropropane), CBDA (cyclobutane-1,2,3,4-tetracarboxylic dianhydride) and CHDA (1,2,4,5-cyclohexanetetracarboxylic dianhydride), and diamine including at least one selected from the group consisting of pPDA (paraphenylene diamine), ODA (4,4'-oxydianiline), TPE-R (1,3-bis(4-aminophenoxy)benzene), TPE-Q (1,4-bis(4-aminophenoxy)benzene), BAPP (2,2-bis[4-(4-aminophenoxy)phenyl]propane), m-tolidine (2,2'-dimethyl-4,4'-diaminobiphenyl), o-tolidine (3,3'-dimethyl-4,4'-diaminobiphenyl), TFDB (2,2'-bis(trifluoromethyl)-[1,1'-biphenyl]-4,4'-diamine) and HFBAPP (2,2-bis[4-(4-aminophenoxy)phenyl] hexafluoropropane).

In addition, the adhesive layer may be 2 to 40% by volume based on the total volume of the core layer and the adhesive layer.

In addition, the polyimide-based matrix may include at least one of fluorine-based particles and ceramic particles.

In addition, the fluorine-based particles may include at least one selected from the group consisting of fluoroethylene (PTFE), perfluoroalkoxy copolymer (PFA, MFA), fluorinated ethylene propylene copolymer (FEP), ethylene-tetrafluoroethylene copolymer (ETFE) and ethylene-chlorotrifluoroethylene copolymer (ECTFE).

In addition, the ceramic particles may include at least one element selected from the group consisting of B, Na, Mg, Al, Si, P, K, Ca and Ti.

In addition, the ceramic particles may include at least one of hollow ceramic particles and non-hollow ceramic particles.

In addition, the present invention provides a low dielectric copper clad laminate, including a core layer having a porous substrate including expanded polytetrafluoroethylene (ePTFE) and having a plurality of pores, and a polyimide-based matrix which is formed by including a polyimide-based compound and filled in the pores of the porous substrate; a copper clad provided on one or both sides of the core layer; and an adhesive layer interposed between the core layer and the copper clad.

[Advantageous Effects]

The low dielectric composite film for a copper clad laminate (CCL) and the low dielectric copper clad laminate including the same according to the present invention have the effects of a remarkably low dielectric constant and dielectric loss, excellent mechanical properties and a remarkably low coefficient of thermal expansion.

[Description of Drawings]

FIG. 1 is a cross-sectional diagram of the low dielectric composite film for a copper clad laminate (CCL) according to an exemplary embodiment of the present invention.

FIG. 2 is a cross-sectional diagram of the low dielectric composite film for a copper clad laminate (CCL) according to another exemplary embodiment of the present invention.

FIG. 3 is a cross-sectional diagram of the low dielectric copper clad laminate for a copper clad laminate (CCL) according to an exemplary embodiment of the present invention.

[Best Mode]

Hereinafter, with reference to the accompanying drawings, the exemplary embodiments of the present invention will be described in detail so that those of ordinary skill in the art to which the present invention pertains may easily practice the present invention. The present invention may be embodied in many different forms and is not limited to the exemplary embodiments described herein. In order to clearly describe the present invention in the drawings, parts irrelevant to the description are omitted, and the same reference numerals are assigned to the same or similar components throughout the specification.

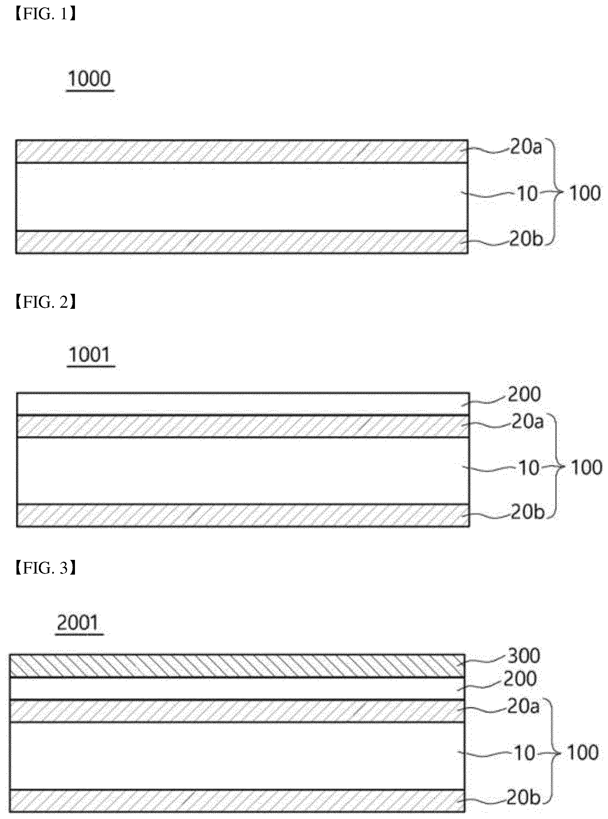

As illustrated in FIGS. 1 and 2, the low dielectric composite films 1000, 1001 according to the present invention is implemented by having a core layer 100 including a porous substrate 10 including a plurality of pores and a polyimide-based matrix filled in the pores of the porous substrate.

The porous substrate performs a function of supporting the low dielectric composite film and performs a function of expressing low dielectric properties, and includes expanded polytetrafluoroethylene (ePTFE).

The porous substrate may have a ratio of tensile strength in MD direction to tensile strength in TD direction of 1: 0.4 to 2.5, and preferably, a ratio of tensile strength in MD direction to tensile strength in TD direction of 1: 0.8 to 1.7. If the ratio of the tensile strength in the MD direction to the tensile strength in the TD direction is less than 1: 0.4 or more than 1: 2.5, deformation may occur in the low dielectric composite film due to a difference in shrinkage and stress in each direction.

In addition, the polyimide-based matrix performs a function of expressing low dielectric properties and reducing the coefficient of thermal expansion.

The polyimide-based matrix partially or completely occludes a plurality of pores of the porous substrate 10 as described above, and preferably, all of the plurality of pores of the porous substrate 10 may be occluded.

Meanwhile, the polyimide-based matrix may be formed by imidization of polyamic acid formed through polymerization of dianhydride including at least one selected from the group consisting of BPDA (3,3',4,4'-Biphenyltetracarboxylic dianhydride), PMDA (pyromellitic dianhydride), ODPA (4,4'-oxydiphthalic anhydride), BTDA (3,3',4,4'-benzophenone tetracarboxylic dianhydride), BPADA (2,2-bis[4-(3,4-dicarboxyphenoxy)phenyl]propane dianhydride), TAHQ (ditricarboxylic anhydride hydroquinone ester), 6FDA (2,2-bis(3,4-anhydrodicarboxyphenyl)hexafluoropropane, CBDA (cyclobutane-1,2,3,4-tetracarboxylic dianhydride) and CHDA (1,2,4,5-cyclohexanetetracarboxylic dianhydride), and diamine including at least one selected from the group consisting of pPDA (paraphenylene diamine), ODA (4,4'-oxydianiline), TPE-R (1,3-bis(4-aminophenoxy)benzene), TPE-Q (1,4-bis(4-aminophenoxy)benzene), BAPP (2,2-bis[4-(4-aminophenoxy)phenyl]propane), m-tolidine (2,2'-dimethyl-4,4'-diaminobiphenyl), o-tolidine (3,3'-dimethyl-4,4'-diaminobiphenyl), TFDB (2,2'-bis(trifluoromethyl)-[1,1'-biphenyl]-4,4'-diamine) and HFBAPP (2,2-bis[4-(4-aminophenoxy)phenyl] hexafluoropropane). Preferably, it may be formed by imidization of polyamic acid formed through polymerization of dianhydride including at least one selected from the group consisting of BPDA (3,3',4,4'-biphenyltetracarboxylic dianhydride), PMDA (pyromellitic dianhydride), ODPA (4,4'-oxydiphthalic anhydride), BTDA (3,3',4,4'-benzophenone tetracarboxylic dianhydride) and 6FDA (2,2-bis(3,4-anhydrodicarboxyphenyl)hexafluoropropane, and diamine including at least one selected from the group consisting of pPDA (paraphenylene diamine), ODA (4,4'-oxydianiline) and TFDB (2,2'-bis(trifluoromethyl)-[1,1'-biphenyl] -4,4'-diamine).

Meanwhile, the polymerization may be carried out in a solvent including at least one selected from the group consisting of DMF (N,N-dimethylformamide), DMAc (N,N-dimethylacetamide), NMP (1-methyl-2-pyrrolidone), NEP (N-ethyl-2-pyrrolidone) GBL (γ-butyrolactone), GVL (γ-valerolactone), DVL (δ-valerolactone), ethylene carbonate, propylene carbonate, m-cresol, p-cresol, acetophenone, THF (tetrahydrofuran), dimethoxyethane, diethoxyethane, dibutyl ether, diethylene glycol dimethyl ether, methyl isobutyl ketone, diisobutyl ketone, cyclohexanone, methyl ethyl ketone, acetone, butanol, ethanol, xylene, toluene and chlorobenzene.

Specifically, the polyimide-based matrix may be formed through a method to be described below. In this case, the method to be described below will be described with an example of using BPDA and PMDA as the dianhydrides and using pPDA and ODA as the diamines.

First, pPDA and ODA are completely dissolved at room temperature in a polar aprotic solvent used for general polyimide polymerization under a nitrogen atmosphere, and among the two types of acid dianhydrides, BPDA is added over 15 to 45 minutes. After stirring the solution for 5 to 15 minutes, PMDA is added over 15 to 45 minutes. Thereafter, the reaction temperature is reacted at 0°C to 60°C for 8 to 24 hours to prepare a polyamic acid solution. In this case, the polyamic acid solution may have a solid content of 5 to 25% by weight, and preferably, a solid content of 10 to 20% by weight, and the polyamic acid solution may have a viscosity of 2,000 to 5,000 cps at 25°C, and preferably, the viscosity may be 2,500 to 4,500 cps. The polyamic acid solution is filtered with a predetermined filter, and an impregnation solution is prepared. Afterwards, the porous substrate is impregnated with the impregnation solution such that the impregnation solution occludes a plurality of pores inside the porous substrate, and then it is primarily dried at 65 to 95°C for 1 to 10 minutes and secondarily dried at 100 to 140°C for 5 to 15 minutes to remove the solvent, thereby preparing a composite film having a porous substrate and polyamic acid provided on both sides and pores of the porous substrate. Finally, a low dielectric composite film 1000, 1001 including a porous substrate 10 and a polyimide matrix may be prepared by imidizing polyamic acid by performing primary heat treatment at 170 to 260°C and secondary heat treatment at 240 to 360°C. In this case, in order to minimize the construction of the film and the occurrence of curl, the heat treatment may be performed in the transverse direction (TD) stretching condition through a tenter (roll stretching machine) facility.

Meanwhile, based on the total weight of the core layer 100, the porous substrate 10 may be 20 to 85% by weight, and preferably, 60 to 80% by weight. If the porous substrate is less than 20% by weight based on the total weight of the core layer, the dielectric constant and dielectric loss of the low dielectric composite film and the low dielectric copper clad laminate increase such that problems may occur where it difficult to use as a substrate material for 5G high frequency., and if it is more than 85% by weight, problems may occur in that the mechanical strength is lowered.

In addition, based on the total volume of the core layer 100, the porous substrate 10 may be 15 to 80% by volume, and preferably, 50 to 75% by volume. If the porous substrate is less than 15% by volume based on the total volume of the core layer, problems may occur in that the dielectric constant and dielectric loss increase, and if it is more than 80% by volume, problems may occur in that the mechanical strength is lowered.

Meanwhile, the core layer 100 may further include polyimide-based layers 20a, 20b provided on at least one of the upper and lower surfaces of the porous substrate 10 and derived from the polyimide-based matrix.

In this case, since the polyimide-based layer is derived from the polyimide-based matrix, it may be formed by including the same compound as the polyimide-based compound of the above-described polyimide-based matrix.

Meanwhile, based on the total volume of the core layer 100, the polyimide-based layer 20a, 20b may be 8 to 80% by volume, and preferably, 10 to 40% by volume. If the polyimide-based layer is less than 8% by volume based on the total volume of the porous substrate and the polyimide-based matrix, problems may occur in that the mechanical strength is lowered, and if it is more than 80% by volume, there may be problem in that the dielectric constant and dielectric loss increase.

In addition, the thickness ratio of the total thickness of the polyimide-based layers 20a, 20b to the thickness of the porous substrate 10 may be 1: 0.2 to 12, and preferably, the thickness ratio may be 1: 4 to 11.5. If the thickness ratio of the total thickness of the polyimide-based layer to the thickness of the porous substrate is less than 1: 0.2, problems may occur in that the dielectric constant and dielectric loss increase, and if the thickness ratio is more than 1: 12, problems may occur in that the mechanical strength is lowered.

Meanwhile, as shown in FIGS. 1 and 2, the core layer 100 may include a first polyimide-based layer 20a and a second polyimide-based layer 20b on the upper and lower surfaces of the porous substrate 10, respectively. Specifically, the first polyimide-based layer 20a may be included on the upper surface of the porous substrate 10, and the second polyimide-based layer 20b may be included on the lower surface of the porous substrate 10.

In this case, the first polyimide-based layer 20a and the second polyimide-based layer 20b may have a thickness ratio of 1: 0.5 to 1.5, and preferably, a thickness ratio of 1: 0.7 to 1.3. If the thickness ratio is out of the above range, interlayer stress non-uniformity may occur and curl may occur in the composite film and/or the copper clad laminate, and deformation may occur due to excessive internal stress.

Meanwhile, the polyimide-based matrix may have an imidization ratio of 90% or more as measured according to Measurement Method 1 below, and preferably, an imidization ratio of 95% or more as measured according to Measurement Method 1 below.

[Measurement Method 1]

Assuming that the imidization ratio of a reference sample imidized at 380°C for 60 minutes is 100%, the peak sizes at wavelengths of 1,700 $cm^{-1}$ and 1,615 $cm^{-1}$ are measured with respect to the polyimide-based matrix through an infrared spectrometer, and after calculating the PI index according to Mathematical Formula 1 below, the imidization ratio is calculated according to Mathematical Formula 2 below.

[Mathematical Formula 1]

$$\text{PI index} = \text{Peak area at wavelength of } 1{,}700 \text{ cm}^{-1} \text{ (PI Peak)} / \text{Peak area at wavelength of } 1{,}615 \text{ cm}^{-1} \text{ (PAA Peak)}$$

[Mathematical Formula 2]

$$\text{Imidization ratio (\%)} = (\text{PI index of polyimide-based matrix} / \text{PI index of reference sample}) \times 100 \text{ (\%)}$$

If the imidization ratio measured according to Measurement Method 1 is less than 90%, the dielectric constant and dielectric loss may increase, and problems may occur in that the coefficient of thermal expansion is increased.

In this case, the PI index may be calculated according to Mathematical Formula 3 below, but the present invention is not limited thereto.

[Mathematical Formula 3]

$$\text{PI index} = \text{Peak area at wavelength of } 1{,}700 \text{ cm}^{-1} \text{ (PI Peak)} / \text{Peak area at wavelength of } 1{,}510 \text{ cm}^{-1} \text{ (PI, PAA peak)}$$

Meanwhile, as illustrated in FIG. 2, the low dielectric composite film 1001 according to an exemplary embodiment of the present invention may further include an adhesive layer 200 on one or both surfaces of the core layer 100.

The adhesive layer 200 performs a function of fixing the copper clad provided in the copper clad laminate to be described below to the low dielectric composite film. The adhesive layer may be applied without limitation as long as it is an adhesive layer formed of an adhesive layer material commonly used in the art, and preferably, it may be an adhesive layer of at least one selected from the group consisting of an epoxy-based adhesive layer, a thermoplastic polyimide-based adhesive layer, a silicone-based adhesive layer and an acrylic adhesive layer.

Meanwhile, based on the total volume of the core layer 100 and the adhesive layer 200, the adhesive layer 200 may be 2 to 40% by volume, and preferably, 4 to 30% by volume. If the adhesive layer is less than 2% by volume based on the total volume of the core layer 100 and the adhesive layer 200, the adhesive force between the copper clad and the polyimide-based matrix is not sufficient, and interlayer peeling in the low dielectric copper clad laminate may occur, and mechanical properties may be reduced. In addition, if the adhesive layer is more than 40% by volume, problems may occur in that the dielectric constant and dielectric loss increase.

Meanwhile, according to another exemplary embodiment of the present invention, the polyimide-based matrix may include at least one of fluorine-based particles and ceramic particles.

The fluorine-based particles may be used without limitation as long as they are fluorine-based particles commonly used in the art, and preferably include at least one selected from the group consisting of fluoroethylene (PTFE), perfluoroalkoxy copolymer (PFA, MFA), fluorinated ethylene propylene copolymer (FEP), ethylene-tetrafluoroethylene copolymer (ETFE) and ethylene-chlorotrifluoroethylene copolymer (ECTFE).

In addition, the ceramic particles may be used without limitation as long as they are ceramic particles commonly used in the art, and preferably include at least one element selected from the group consisting of B, Na, Mg, Al, Si, P, K, Ca and Ti. In this case, the composition of the ceramic particles may include the above-mentioned element, and since the method of providing the above-mentioned element may vary depending on the purpose, such as forming the above-mentioned element by doping the surface, the present invention does not particularly limit the same.

In addition, the ceramic particles may include at least one of hollow ceramic particles including a hollow part and non-hollow granular ceramic particles.

Meanwhile, depending on the size of the above-described fluorine-based particles and/or ceramic particles, the above-mentioned particles are not provided in the polyimide-based matrix provided inside the porous substrate, but only the polyimide layer may include the above-mentioned particles, but the present invention is not limited thereto.

As illustrated in FIG. 3, the low dielectric copper clad laminate 2000 according to the present invention is implemented by including a porous substrate 10 including a plurality of pores, a core layer 100 having a polyimide-based matrix filled in the pores of the porous substrate, a copper clad 300 provided on one or both surfaces of the core layer 100, and an adhesive layer 200 interposed between the core layer and the copper clad.

The copper clad 300 may be a copper clad having known specifications that can be commonly used in the art, and the present invention does not particularly limit the same.

[Modes of the Invention]

The present invention will be described in more detail through the following examples, but the following examples are not intended to limit the scope of the present invention, which should be construed to aid understanding of the present invention.

**[Example]**

<Example 1: Preparation of low dielectric composite film for copper clad laminate (CCL)>

First, pPDA and ODA were added to DMAc, which is a polymerization solvent, under a nitrogen atmosphere and completely dissolved at room temperature, and BPDA was added over 30 minutes. After stirring the solution for 10 minutes, PMDA was added over 30 minutes. Thereafter, a polyamic acid solution was prepared by reacting at a temperature of 20°C or less for 16 hours. Through this, a polyamic acid solution having a solid content of 15% by weight and a viscosity of 3,500 cps at 25°C was obtained, and after it was filtered with a MINIFLOW filter of CHUNGSOO TECHNOFIL (CTS-CAP10 A grade), and finally, an impregnation solution with a solid content of 15% by weight was prepared

Then, after impregnating a porous substrate including a plurality of pores, which is expanded polytetrafluoroethylene (ePTFE) having a thickness of 40 $\mu$m, into the prepared impregnation solution to occlude all of the plurality of pores of the porous substrate, in order to remove the solvent, primary drying was performed at a temperature of 80°C for 5 minutes, and secondary drying was performed at a temperature of 120°C for 10 minutes. In this case, the tensile strength in the MD direction of the porous substrate was 30 MPa, and the tensile strength in the TD direction was 25 MPa, and the ratio of the tensile strength in the MD direction to the tensile strength in the TD direction was 1: 0.8.

Thereafter, the polyamic acid was imidized by performing a primary heat treatment at a temperature of 250°C for 10 minutes and a secondary heat treatment at a temperature of 350°C for 5 minutes, and a low dielectric composite film including the porous substrate and the polyimide-based matrix as illustrated in FIG. 1 was prepared. In this case, in order to minimize the construction of the film and the occurrence of curl, heat treatment was performed under the transverse direction (TD) stretching condition through a tenter (roll stretching machine) facility.

In the prepared low dielectric composite film, the thickness of the first polyimide-based layer and the second polyimide-based layer was 5 $\mu$m, respectively, the porous substrate was 73% by weight based on the total weight of the prepared low dielectric composite film, and the porous substrate was 64% by volume and the polyimide-based layer was 25% by volume based on the total volume of the composite film. Further, in the prepared low dielectric composite film, the imidization ratio of the polyimide-based matrix measured according to Measurement Method 1 below was 98%.

[Measurement Method 1]

Assuming that the imidization ratio of a reference sample imidized at 380°C for 60 minutes is 100%, the peak sizes at wavelengths of 1,700 $cm^{-1}$ and 1,615 $cm^{-1}$ are measured with respect to the polyimide-based matrix through an infrared spectrometer, and after calculating the PI index according to Mathematical Formula 1 below, the imidization ratio is calculated according to Mathematical Formula 2 below.

[Mathematical Formula 1]

$$PI\ index = Peak\ area\ at\ wavelength\ of\ 1{,}700\ cm^{-1}\ (PI\ Peak)\ /\ Peak\ area\ at\ wavelength\ of\ 1{,}615\ cm^{-1}\ (PAA\ Peak).$$

[Mathematical Formula 2]

$$Imidization\ ratio\ (\%) = (PI\ index\ of\ polyimide\text{-}based\ matrix\ /\ PI\ index\ of\ reference\ sample) \times 100\ (\%).$$

<Examples 2 to 13 and Comparative Examples 1 to 2>

Low dielectric composite films as shown in Tables 1 to 3 were prepared in the same manner as in Example 1, except that the weight % and the volume % of the porous substrate, the volume % of the polyimide-based layer, the thickness ratio of the total thickness of the polyimide-based layer to the thickness of the porous substrate, the imidization ratio of the polyimide-based matrix, whether the porous substrate was included and whether the polyimide-based matrix was included were changed.

<Experimental Example 1>

The following physical properties were evaluated for each of the low dielectric composite films prepared according to examples and comparative Examples, and the results are shown in Tables 1 to 3.

**1. Measurement of dielectric constant and dielectric loss**

For each low dielectric composite film, the dielectric constant and dielectric loss in the gigahertz (GHz) region of the film-type sample were measured through a resonant cavity by using a network analyzer (E8364A (45MHz to 50GHz), Agilent Technologies).

**2. Evaluation of mechanical properties**

For each low dielectric composite film, the tensile strength was measured according to ASTM-D882 standards by using a universal testing machine (UTM).

**3. Measurement of coefficient of thermal expansion**

For each low dielectric composite film, the coefficient of thermal expansion was measured by using a thermomechanical analyzer (Pyris Diamond TMA, Perkin Elmer instrument). After measuring in the range of 30 to 400°C under a nitrogen stream under conditions of a 10°C/min temperature increase, the average value between 50 to 250°C was calculated.

[Table 1]

| Classification | | | Example 1 | Example 2 | Example 3 | Example 4 | Example 5 |
|---|---|---|---|---|---|---|---|
| Porous substrate | | Thickness ($\mu$m) | 40 | 40 | 40 | 40 | 40 |
| | | Weight ratio based on total (% by weight) | 73 | 20 | 60 | 80 | 90 |
| | | Volume ratio based on total (% by volume) | 64 | 14 | 50 | 72 | 85 |
| | | Tensile strength ratio in MD direction and TD direction | 1:0.8 | 1:0.8 | 1:0.8 | 1:0.8 | 1:0.8 |
| Polyimide-based layer | | Thickness of first polyimide-based layer ($\mu$m) | 5 | 5 | 5 | 5 | 2.5 |
| | | Thickness of second polyimide-based layer ($\mu$m) | 5 | 5 | 5 | 5 | 2.5 |
| | | Total thickness ($\mu$m) | 10 | 10 | 10 | 10 | 5 |
| | | PI layer volume ratio based on total (% by volume) | 25 | 25 | 25 | 25 | 9 |
| Thickness ratio of total thickness of polyimide-based layer to thickness of porous substrate | | | 1:4 | 1:4 | 1:4 | 1:4 | 1:8 |
| Imidization ratio of polyimide-based matrix (%) | | | 98 | 98 | 98 | 98 | 98 |
| Dielectric constant (@2.2GHz) | | | 2.50 | 3.04 | 2.60 | 2.39 | 2.25 |
| Dielectric loss (@2.2GHz) | | | 0.0017 | 0.0034 | 0.0021 | 0.0015 | 0.0013 |
| Evaluation of tensile strength (MPa) | | | 200 | 250 | 220 | 140 | 80 |
| Coefficient of thermal expansion (ppm/°C) | | | 15 | 8 | 13 | 17 | 20 |

[Table 2]

| Classification | | | Example 6 | Example 7 | Example 8 | Example 9 | Example 10 |
|---|---|---|---|---|---|---|---|
| Porous substrate | | Thickness ($\mu$m) | 2 | 47 | 40 | 40 | 40 |
| | | Weight ratio based on total (% by weight) | 15 | 80 | 73 | 73 | 73 |
| | | Volume ratio based on total (% by volume) | 10 | 75 | 64 | 64 | 64 |
| | | Tensile strength ratio in MD direction and TD direction | 1:0.8 | 1:0.9 | 1:0.9 | 1:0.9 | 1:0.2 |
| Polyimide-based layer | | Thickness of first polyimide-based layer ($\mu$m) | 12.5 | 1.5 | 5 | 5 | 5 |
| | | Thickness of second polyimide-based layer ($\mu$m) | 12.5 | 1.5 | 5 | 5 | 5 |
| | | Total thickness ($\mu$m) | 20 | 3 | 10 | 10 | 10 |
| | | PI layer volume ratio based on total (% by volume) | 85 | 6 | 25 | 25 | 25 |
| Thickness ratio of total thickness of polyimide-based layer and thickness of porous substrate | | | 1:0.08 | 1:16.67 | 1:4 | 1:4 | 1:4 |

(continued)

| Classification | Example 6 | Example 7 | Example 8 | Example 9 | Example 10 |
|---|---|---|---|---|---|
| Imidization ratio of polyimide-based matrix (%) | 98 | 98 | 97 | 87 | 98 |
| Dielectric constant (@2.2GHz) | 3.04 | 2.40 | 2.55 | 2.56 | 2.47 |
| Dielectric loss (@2.2GHz) | 0.0023 | 0.0015 | 0.0025 | 0.0121 | 0.0017 |
| Evaluation of tensile strength (MPa) | 240 | 110 | 170 | 120 | 160 |
| Coefficient of thermal expansion (ppm/°C) | 8 | 13 | 15 | 38 | 21 |

[Table 3]

| Classification | | Example 11 | Example 12 | Example 13 | Comparative Example 1 | Comparative Example 2 |
|---|---|---|---|---|---|---|
| Porous substrate | Thickness ($\mu$m) | 40 | 40 | 40 | - | 50 |
| | Weight ratio based on total (% by weight) | 73 | 73 | 73 | - | 100 |
| | Volume ratio based on total (% by volume) | 64 | 64 | 64 | - | 100 |
| | Tensile strength ratio in MD direction and TD direction | 1:1.3 | 1:1.7 | 1:3 | - | 1:1.1 |
| Polyimide -based layer | Thickness of first polyimide-based layer ($\mu$m) | 5 | 5 | 5 | 25 | - |
| | Thickness of second polyimide-based layer ($\mu$m) | 5 | 5 | 5 | 25 | - |
| | Total thickness ($\mu$m) | 10 | 10 | 10 | 50 | - |
| | PI layer volume ratio based on total (% by volume) | 25 | 25 | 25 | 100 | - |
| Thickness ratio of total thickness of polyimide-based layer to thickness of porous substrate | | 1:4 | 1:4 | 1:4 | - | - |
| Imidization ratio of polyimide-based matrix (%) | | 98 | 98 | 98 | 98 | - |
| Dielectric constant (@2.2GHz) | | 2.48 | 2.52 | 2.54 | 3.5 | 1.7 |
| Dielectric loss (@2.2GHz) | | 0.0017 | 0.0017 | 0.0018 | 0.0042 | 0.0001 |
| Evaluation of tensile strength (MPa) | | 160 | 160 | 160 | 300 | 30 |
| Coefficient of thermal expansion (ppm/°C) | | 14 | 17 | 21 | 3 | - |

As can be seen from Tables 1 to 3, it was found that Examples 1, 3, 4, 8, 11 and 12, which satisfied all of the weight % and the volume % of the porous substrate, the volume % of the polyimide-based layer, the thickness ratio of the total thickness of the polyimide-based layer to the thickness of the porous substrate, the imidization ratio of the polyimide-based matrix, whether the porous substrate was included and whether the polyimide-based matrix according to the present invention, simultaneously exhibited all of the effects of a remarkably low dielectric constant and dielectric loss, excellent mechanical properties and a low coefficient of thermal expansion, compared to Examples 2, 5, 6, 7, 9, 10, 13 and Comparative Examples 1 to 2, in which any one of the above was omitted.

Meanwhile, since the coefficient of thermal expansion was excessively high in Comparative Example 2, measurement was impossible.

<Examples 14 to 19>

Low dielectric composite films were prepared in the same manner as in Example 1, except that BPDA and PMDA, which are the dianhydrides of Example 1, were changed to BPDA and ODPA (Example 14), BPDA and BTDA (Example 15), BPDA and 6FDA (Example 16), PMDA and ODPA (Example 17), PMDA and BTDA (Example 18) and PMDA and 6FDA (Example 19).

<Examples 20 to 21>

Low dielectric composite films were prepared in the same manner as in Example 1, except that pPDA and ODA, which are the diamines of Example 1, were changed to pPDA and TFDB (Example 20) and ODA and TFDB (Example 21).

<Examples 22 to 24>

Low dielectric composite films were prepared in the same manner as in Example 1, except that BPDA and PMDA, which are the dianhydrides of Example 1, were changed to 6FDA (Example 22), ODPA (Example 23) and BTDA (Example 24) to prepare polyamic acid in which each of the above was individually applied.

<Examples 25 to 26>

Low dielectric composite films were prepared in the same manner as in Example 1, except that pPDA and ODA, which are the diamines of Example 1, were changed to TFDB (Example 25) and BAPP (Example 26) to prepare polyamic acid in which each of the above was individually applied.

<Experimental Example 2>

The following physical properties were evaluated for each of the low dielectric composite films prepared according to Examples 14 to 26, and the results are shown in Tables 4 and 5.

**1. Measurement of dielectric constant and dielectric loss**

For each low dielectric composite film, the dielectric constant and dielectric loss in the gigahertz (GHz) region of the film-type sample were measured through a resonant cavity by using a network analyzer (E8364A (45MHz to 50GHz), Agilent Technologies).

**2. Evaluation of mechanical properties**

For each low dielectric composite film, the tensile strength was measured according to ASTM-D882 standards by using a universal testing machine (UTM).

**3. Measurement of coefficient of thermal expansion**

For each low dielectric composite film, the coefficient of thermal expansion was measured by using a thermomechanical analyzer (Pyris Diamond TMA, Perkin Elmer instrument). After measuring in the range of 30 to 400°C under a nitrogen stream under conditions of a 10°C/min temperature increase, the average value between 50 to 250°C was calculated.

[Table 4]

| Classification | | Example 14 | Example 15 | Example 16 | Example 17 | Example 18 | Example 19 |
|---|---|---|---|---|---|---|---|
| Dianhydride | Type | BPDA, ODPA | BPDA, BTDA | BPDA, 6FDA | PMDA, ODPA | PMDA, BTDA | PMDA, 6FDA |
| Diamine | Type | pPDA, ODA | pPDA, ODA | pPDA, ODA | pPDA, ODA | pPDA, ODA | pPDA, ODA |

(continued)

| Classification | Example 14 | Example 15 | Example 16 | Example 17 | Example 18 | Example 19 |
|---|---|---|---|---|---|---|
| Dielectric constant (@2.2GHz) | 2.52 | 2.45 | 2.35 | 2.65 | 2.46 | 2.38 |
| Dielectric loss (@2.2GHz) | 0.0026 | 0.0025 | 0.0029 | 0.0028 | 0.0025 | 0.0028 |
| Evaluation of tensile strength (MPa) | 157 | 165 | 138 | 139 | 152 | 126 |
| Coefficient of thermal expansion (ppm/°C) | 26 | 24 | 28 | 23 | 22 | 27 |

[Table 5]

| Classification | | Example 20 | Example 21 | Example 22 | Example 23 | Example 24 | Example 25 | Example 26 |
|---|---|---|---|---|---|---|---|---|
| Dianhydride | Type | BPDA, PMDA | BPDA, PMDA | 6FDA | ODPA | BTDA | BPDA, PMDA | BPDA, PMDA |
| Diamine | Type | pPDA, TFDB | ODA, TFDB | PPDA. ODA | pPDA, ODA | pPDA, ODA | TFDB | BAPP |
| Dielectric constant (@2.2GHz) | | 2.46 | 2.54 | 2.35 | 2.35 | 2.46 | 2.54 | 2.68 |
| Dielectric loss (@2.2GHz) | | 0.0026 | 0.0028 | 0.0043 | 0.0032 | 0.0027 | 0.0032 | 0.0034 |
| Evaluation of tensile strength (MPa) | | 154 | 138 | 98 | 101 | 100 | 101 | 83 |
| Coefficient of thermal expansion (ppm/°C) | | 21 | 27 | 52 | 42 | 38 | 44 | 38 |

As can be seen from Tables 4 and 5, it was found that Examples 14 to 21, which satisfied the types of dianhydride and diamine according to the present invention, simultaneously exhibited all of the effects of a remarkably low dielectric constant and dielectric loss, excellent mechanical properties and a low coefficient of thermal expansion, compared to Examples 22 to 26 that did not satisfy the above.

<Preparation Example 1>

After coating the one-component epoxy solution including a latent curing agent and an acrylic resin on the upper surface of the low dielectric composite film prepared according to Example 1, it was dried at a temperature of 100°C to prepare a low dielectric composite film having an adhesive layer with a thickness of 6 $\mu$m. Herein, it included 10 parts by weight of dicyandiamide (DICY) as a latent curing agent and an acrylic resin based on 100 parts by weight of the one-component epoxy. In this case, the adhesive layer was 6% by volume based on the total volume of the prepared low dielectric composite film.

<Preparation Examples 2 to 6>

Low dielectric composite films as shown in Table 6 below were prepared in the same manner as in Preparation Example 1, except that the volume % of the adhesive layer based on the total volume of the low dielectric composite film was changed.

<Experimental Example 3>

The following physical properties were evaluated for the low dielectric composite films prepared according to Preparation Examples 1 to 6, and the results are shown in Table 6 below.

**1. Measurement of dielectric constant and dielectric loss**

For each low dielectric composite film, the dielectric constant and dielectric loss in the gigahertz (GHz) region of the film-type sample were measured through a resonant cavity by using a network analyzer (E8364A (45MHz to 50GHz), Agilent Technologies).

**2. Measurement of adhesive strength**

Based on the evaluation standards of IPC-TM-650 2.4.9.1 for each low dielectric composite film according to the preparation examples, the time point at which the copper layer was peeled was measured and evaluated by pulling it up in a 90-degree direction.

[Table 6]

| Classification | | Preparation Example 1 | Preparation Example 2 | Preparation Example 3 | Preparation Example 4 | Preparation Example 6 |
|---|---|---|---|---|---|---|
| Adhesive layer | Volume ratio based on total (% by volume) | 6 | 1 | 4 | 30 | 50 |
| Dielectric constant (@2.2GHz) | | 2.57 | 2.52 | 2.53 | 2.59 | 3.16 |
| Dielectric loss (@2.2GHz) | | 0.0052 | 0.0038 | 0.0042 | 0.0055 | 0.0194 |
| Adhesive strength (kgf/cm) | | 1.4 | 0.7 | 1 | 1.1 | 1.2 |

As can be seen from Table 6, it was found that Preparation Examples 1, 3 and 4, which satisfied the volume % of the adhesive layer and the volume % of the polyimide-based layer according to the present invention, simultaneously exhibited all of the effects of a remarkably low dielectric constant and dielectric loss and an excellent adhesive strength, compared to Preparation Examples 2 and 6, which did not satisfy the above.

Although an exemplary embodiment of the present invention has been described above, the spirit of the present invention is not limited to the exemplary embodiment presented herein, and those skilled in the art who understand the spirit of the present invention may easily suggest other exemplary embodiments by changing, modifying, deleting or adding components within the scope of the same spirit, but this will also fall within the scope of the present invention.

**Claims**

1. A low dielectric composite film for a copper clad laminate (CCL), comprising:
   a core layer having a porous substrate comprising expanded polytetrafluoroethylene (ePTFE) and having a plurality of pores, and a polyimide-based matrix which is formed by comprising a polyimide-based compound and filled in the pores of the porous substrate.

2. The low dielectric composite film of claim 1, wherein the porous substrate is 20 to 85% by weight based on the total weight of the core layer.

3. The low dielectric composite film of claim 1, wherein the porous substrate is 15 to 80% by volume based on the total volume of the core layer.

4. The low dielectric composite film of claim 1, wherein the core layer is provided on at least one of the upper and lower surfaces of the porous substrate and further comprises a polyimide-based layer derived from the polyimide-based matrix.

5. The low dielectric composite film of claim 4, wherein the polyimide-based layer is 8 to 80% by volume based on the total volume of the core layer.

6. The low dielectric composite film of claim 1, wherein the porous substrate has a ratio of tensile strength in MD direction to tensile strength in TD direction of 1: 0.4 to 2.5.

7. The low dielectric composite film of claim 4, wherein the thickness ratio of the total thickness of the polyimide-based layer to the thickness of the porous substrate is 1:0.2 to 12.

8. The low dielectric composite film of claim 4, wherein the core layer comprises a first polyimide-based layer and a second polyimide-based layer on the upper and lower surfaces of the porous substrate, respectively, and wherein the first polyimide-based layer and the second polyimide-based layer have a thickness ratio of 1: 0.5 to 1.5.

9. The low dielectric composite film of claim 1, wherein the polyimide-based matrix has an imidization ratio of 90% or more as measured according to Measurement Method 1 below:

[Measurement Method 1]
Assuming that the imidization ratio of a reference sample imidized at 380°C for 60 minutes is 100%, the peak sizes at wavelengths of 1,700 cm$^{-1}$ and 1,615 cm$^{-1}$ are measured with respect to the polyimide-based matrix through an infrared spectrometer, and after calculating the PI index according to Mathematical Formula 1 below, the imidization ratio is calculated according to Mathematical Formula 2 below.

[Mathematical Formula 1]

$$\text{PI index} = \text{Peak area at wavelength of } 1{,}700 \text{ cm}^{-1} \text{ (PI Peak) / Peak area at wavelength of } 1{,}615 \text{ cm}^{-1} \text{ (PAA Peak)}$$

[Mathematical Formula 2]

$$\text{Imidization ratio (\%)} = \text{(PI index of polyimide-based matrix / PI index of reference sample)} \times 100 \text{ (\%)}$$

10. The low dielectric composite film of claim 1, further comprising:
an adhesive layer on one or both sides of the core layer.

11. The low dielectric composite film of claim 1, wherein the polyimide-based matrix is formed by imidization of polyamic acid formed through polymerization of dianhydride comprising at least one selected from the group consisting of BPDA (3,3',4,4'-Biphenyltetracarboxylic dianhydride), PMDA (pyromellitic dianhydride), ODPA (4,4'-oxydiphthalic anhydride), BTDA (3,3',4,4'-benzophenone tetracarboxylic dianhydride), BPADA (2,2-bis[4-(3,4-dicarboxyphenoxy)phenyl]propane dianhydride), TAHQ (ditricarboxylic anhydride hydroquinone ester), 6FDA (2,2-bis(3,4-anhydrodicarboxyphenyl)hexafluoropropane), CBDA (cyclobutane-1,2,3,4-tetracarboxylic dianhydride) and CHDA (1,2,4,5-cyclohexanetetracarboxylic dianhydride), and diamine comprising at least one selected from the group consisting of pPDA (paraphenylene diamine), ODA (4,4'-oxydianiline), TPE-R (1,3-bis(4-aminophenoxy)benzene), TPE-Q (1,4-bis(4-aminophenoxy)benzene), BAPP (2,2-bis[4-(4-aminophenoxy)phenyl]propane), m-tolidine (2,2'-dimethyl-4,4'-diaminobiphenyl), o-tolidine (3,3'-dimethyl-4,4'-diaminobiphenyl), TFDB (2,2'-bis(trifluoromethyl)-[1,1'-biphenyl]-4,4'-diamine) and HFBAPP (2,2-bis[4-(4-aminophenoxy)phenyl] hexafluoropropane).

12. The low dielectric composite film of claim 10, wherein the adhesive layer is 2 to 40% by volume based on the total volume of the core layer and the adhesive layer.

13. The low dielectric composite film of claim 4, wherein the polyimide-based matrix comprises at least one of fluorine-based particles and ceramic particles.

14. The low dielectric composite film of claim 13, wherein the fluorine-based particles comprise at least one selected from the group consisting of fluoroethylene (PTFE), perfluoroalkoxy copolymer (PFA, MFA), fluorinated ethylene propylene copolymer (FEP), ethylene-tetrafluoroethylene copolymer (ETFE) and ethylene-chlorotrifluoroethylene copolymer (ECTFE).

**15.** The low dielectric composite film of claim 13, wherein the ceramic particles comprise at least one element selected from the group consisting of B, Na, Mg, Al, Si, P, K, Ca and Ti.

**16.** The low dielectric composite film of claim 13, wherein the ceramic particles comprise at least one of hollow ceramic particles and non-hollow ceramic particles.

**17.** A low dielectric copper clad laminate, comprising:

a core layer having a porous substrate comprising expanded polytetrafluoroethylene (ePTFE) and having a plurality of pores, and a polyimide-based matrix which is formed by comprising a polyimide-based compound and filled in the pores of the porous substrate;
a copper clad provided on one or both sides of the core layer; and
an adhesive layer interposed between the core layer and the copper clad.

【FIG. 1】

1000

【FIG. 2】

1001

【FIG. 3】

2001

## INTERNATIONAL SEARCH REPORT

International application No.

**PCT/KR2020/016692**

| A. | CLASSIFICATION OF SUBJECT MATTER |
|---|---|

**B32B 27/36**(2006.01)i; **B32B 27/08**(2006.01)i; **B32B 27/28**(2006.01)i; **B32B 27/18**(2006.01)i; **C08J 9/42**(2006.01)i; **B32B 15/08**(2006.01)i; **B32B 15/20**(2006.01)i; **B32B 7/12**(2006.01)i; **B32B 7/025**(2019.01)i

According to International Patent Classification (IPC) or to both national classification and IPC

| B. | FIELDS SEARCHED |
|---|---|

Minimum documentation searched (classification system followed by classification symbols)

B32B 27/36(2006.01); B01D 67/00(2006.01); B01D 69/02(2006.01); B32B 15/08(2006.01); B32B 15/20(2006.01); B32B 27/00(2006.01); B32B 27/08(2006.01); B32B 27/18(2006.01); B32B 27/30(2006.01); B32B 27/34(2006.01); C08J 5/18(2006.01); H05K 1/03(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 동박(copper foil), 폴리테트라플루오로에틸렌(polytetrafluoroethylene), 폴리이미드(polyimide), 기공(pore)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-1991-0008872 B1 (DAIKIN INDUSTRIES, LTD.) 24 October 1991 (1991-10-24)<br>See claims 1-5; examples 1 and 9-11; and page 1. | 1-17 |
| Y | KR 10-2008-0015022 A (GORE ENTERPRISE HOLDINGS, INC.) 15 February 2008 (2008-02-15)<br>See claims 1 and 3. | 1-17 |
| Y | KR 10-1998-0081168 A (SUMITOMO CHEMICAL CO., LTD.) 25 November 1998 (1998-11-25)<br>See table 1. | 6 |
| Y | JP 2011-051203 A (TOYOBO CO., LTD.) 17 March 2011 (2011-03-17)<br>See claims 1 and 4; and paragraphs [0002] and [0042]. | 8-10,12,17 |
| Y | KR 10-2016-0038730 A (LG CHEM, LTD.) 07 April 2016 (2016-04-07)<br>See claims 1 and 9. | 13-16 |

| ✓ Further documents are listed in the continuation of Box C. | ✓ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 June 2021** | **07 June 2021** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

| International application No. |
| --- |
| **PCT/KR2020/016692** |

| **C.** | **DOCUMENTS CONSIDERED TO BE RELEVANT** | |
| --- | --- | --- |
| Category* | Citation of document, with indication, where appropriate, of the relevant passages | Relevant to claim No. |
| Y | KR 10-2020-0054101 A (SKCKOLON PI INC.) 19 May 2020 (2020-05-19)<br>See claims 1 and 3. | 15-16 |

Form PCT/ISA/210 (second sheet) (July 2019)

**INTERNATIONAL SEARCH REPORT**
Information on patent family members

International application No.

**PCT/KR2020/016692**

| Patent document cited in search report | | | Publication date (day/month/year) | Patent family member(s) | | | Publication date (day/month/year) |
|---|---|---|---|---|---|---|---|
| KR | 10-1991-0008872 | B1 | 24 October 1991 | CA | 1326412 | C | 25 January 1994 |
| | | | | DE | 68927127 | T2 | 20 February 1997 |
| | | | | EP | 0340737 | A2 | 08 November 1989 |
| | | | | EP | 0340737 | A3 | 29 May 1991 |
| | | | | EP | 0340737 | B1 | 11 September 1996 |
| | | | | KR | 10-1989-0015863 | A | 27 November 1989 |
| | | | | US | 4985297 | A | 15 January 1991 |
| KR | 10-2008-0015022 | A | 15 February 2008 | CA | 2609519 | A1 | 30 November 2006 |
| | | | | CA | 2609519 | C | 29 September 2015 |
| | | | | CN | 101218013 | A | 09 July 2008 |
| | | | | CN | 104959041 | A | 07 October 2015 |
| | | | | EP | 1885476 | A2 | 13 February 2008 |
| | | | | EP | 1885476 | B1 | 08 July 2015 |
| | | | | HK | 1108852 | A1 | 20 November 2015 |
| | | | | JP | 2008-542064 | A | 27 November 2008 |
| | | | | JP | 5307536 | B2 | 02 October 2013 |
| | | | | KR | 10-1393173 | B1 | 21 May 2014 |
| | | | | NO | 341096 | B1 | 21 August 2017 |
| | | | | RU | 2007148409 | A | 27 June 2009 |
| | | | | RU | 2435631 | C2 | 10 December 2011 |
| | | | | WO | 2006-127946 | A2 | 30 November 2006 |
| | | | | WO | 2006-127946 | A3 | 01 March 2007 |
| KR | 10-1998-0081168 | A | 25 November 1998 | CA | 2234317 | A1 | 08 October 1998 |
| | | | | CA | 2234317 | C | 17 June 2008 |
| | | | | DE | 69836996 | T2 | 25 October 2007 |
| | | | | EP | 0870795 | A1 | 14 October 1998 |
| | | | | EP | 0870795 | B1 | 31 January 2007 |
| | | | | ES | 2279555 | T3 | 16 August 2007 |
| | | | | JP | 10-338809 | A | 22 December 1998 |
| | | | | TW | 515812 | A | 01 January 2003 |
| | | | | TW | 515812 | B | 01 January 2003 |
| | | | | US | 6121171 | A | 19 September 2000 |
| JP | 2011-051203 | A | 17 March 2011 | None | | | |
| KR | 10-2016-0038730 | A | 07 April 2016 | CN | 105684560 | A | 15 June 2016 |
| | | | | CN | 105684560 | B | 20 September 2019 |
| | | | | EP | 3045309 | A1 | 20 July 2016 |
| | | | | JP | 2017-525585 | A | 07 September 2017 |
| | | | | JP | 6402416 | B2 | 10 October 2018 |
| | | | | TW | 201625408 | A | 16 July 2016 |
| | | | | TW | I615276 | B | 21 February 2018 |
| | | | | US | 10112368 | B2 | 30 October 2018 |
| | | | | US | 2016-0375657 | A1 | 29 December 2016 |
| | | | | WO | 2016-052873 | A1 | 07 April 2016 |
| KR | 10-2020-0054101 | A | 19 May 2020 | CN | 111433027 | A | 17 July 2020 |
| | | | | WO | 2020-096410 | A1 | 14 May 2020 |

Form PCT/ISA/210 (patent family annex) (July 2019)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020200115972